# FASCICULE DE BREVET EUROPEEN

(11) **EP 2 676 343 B1**
(45) Date de publication et mention de la délivrance du brevet: **12.11.2014**
(21) Numéro de dépôt: 12700687.2
(22) Date de dépôt: 19.01.2012
(51) Int. Cl.: H02B 1/044, H01H 19/02, F16B 37/04

(54) **DISPOSITIF DE COMMANDE OU DE SIGNALISATION ELECTRIQUE**
ELEKTRISCHES STEUERUNGS- ODER SIGNALISIERUNGSVORRICHTUNG
ELECTRIC CONTROL OR SIGNALING DEVICE

(30) Priorité: 16.02.2011 FR 1151275
(43) Date de publication de la demande: 25.12.2013
(73) Titulaire: Schneider Electric Industries SAS, 92500 Rueil-Malmaison (FR)
(72) Inventeur: THIZON, Patrice, F-16600 Ruelle sur Touvre (FR); BARDY, Eric, F-16730 Linars (FR)
(74) Mandataire: Bié, Nicolas
(86) Numéro de dépôt international: PCT/EP2012/050751
(87) Numéro de publication internationale: WO 2012/110274

(56) Documents cités:
- EP-A1- 0 326 808
- EP-A1- 2 053 712
- DE-A1- 10 330 853
- DE-C1- 19 636 706
- GB-A- 778 625

## Description

La présente invention se rapporte à un dispositif de commande ou de signalisation électrique de type bouton-poussoir, bouton tournant, voyant lumineux ou organe analogue comportant une même architecture. L'invention concerne plus particulièrement les moyens de fixation d'un tel dispositif de commande ou de signalisation électrique.

De manière connue, un dispositif de commande ou de signalisation électrique utilisé dans l'industrie est destiné à être assemblé à travers une ouverture réalisée dans une paroi. Il comporte un corps tubulaire pouvant être engagé dans l'ouverture de la paroi et pouvant s'apparier, à l'aide de moyens de verrouillage, à une embase destinée à recevoir au moins un bloc de contacts électriques et des moyens de fixation agissant sur la face interne de la paroi pour fixer le dispositif sur la paroi.

Dans l'état de la technique, les moyens de fixation employés sont par exemple constitués par un écrou vissé sur un filetage du corps tubulaire du dispositif ou, comme décrits dans le brevet EP0452462 ou EP0889564, constitués par une embase qui s'assemble au corps tubulaire et porte des blocs de contact, cette embase portant des moyens d'accrochage tels que des vis pointeau ou des bras d'accrochage pivotants manoeuvrés au moyen d'une vis.

Ces moyens de fixation sont soit trop complexes, donc trop coûteux, soit insatisfaisants car ne permettant pas de remplir toutes les fonctions comme par exemple la mise à la terre du dispositif.

Le but de l'invention est donc de proposer un dispositif de commande ou de signalisation électrique, comme connu par DE 10330853, comportant des moyens de fixation permettant de remplir la fonction de fixation de manière simple et peu coûteuse et la fonction de mise à la terre sans ajouter d'élément spécifique.

Ce but est atteint par un dispositif de commande ou de signalisation électrique destiné à être assemblé à travers une ouverture réalisée dans une paroi et comportant un corps métallique tubulaire destiné à venir en appui contre une première face de la paroi, le corps comportant une partie cylindrique filetée destinée à être engagée dans l'ouverture et un dispositif de fixation comportant un anneau de serrage métallique apte à se visser sur la partie cylindrique filetée du corps pour fixer le dispositif de commande ou de signalisation à travers l'ouverture, le dispositif de fixation comportant également une plaque de fixation métallique destinée à venir s'appliquer contre une deuxième face de la paroi, opposée à la première face, sous l'action de l'anneau de serrage, ladite plaque de fixation comportant une ouverture destinée à être traversée par le corps du dispositif et des moyens de maintien de l'anneau de serrage permettant de solidariser l'anneau de serrage à la plaque de fixation, lesdits moyens de maintien étant agencés pour empêcher une translation de l'anneau de serrage par rapport à la plaque de fixation et pour laisser l'anneau de serrage libre en rotation par rapport à la plaque de fixation.

Selon une particularité, la plaque de fixation comporte des pointes saillantes destinées à venir en contact avec la deuxième face de la paroi.

Selon une variante de réalisation, à la place des pointes saillantes, la plaque de fixation comporte des dents saillantes se dressant pour venir en contact avec la paroi et agencées pour assurer un montage affleurant du dispositif de commande ou de signalisation dans l'ouverture.

Selon une autre particularité, les moyens de maintien comportent plusieurs rabats répartis sur le pourtour de l'ouverture réalisée à travers la plaque de fixation.

Selon une autre particularité, la plaque de fixation comporte des moyens de guidage du corps du dispositif de commande ou de signalisation.

Selon une autre particularité, la partie cylindrique du corps comporte un ergot destiné à coopérer avec une fente (510) correspondante de l'anneau de serrage.

Selon une autre particularité, la plaque de fixation comporte une borne de connexion apte à se raccorder à une cosse connectée à un fil de terre.

D'autres caractéristiques et avantages vont apparaître dans la description détaillée qui suit en se référant à un mode de réalisation donné à titre d'exemple et représenté par les dessins annexés sur lesquels :
- la figure 1 représente, en perspective et en éclaté, le dispositif de fixation employé dans le dispositif de commande ou de signalisation électrique de l'invention,
- les figures 2 et 3 représentent, respectivement en vue de dessus et en vue de côté, le dispositif de fixation de l'invention assemblé,
- la figure 4 représente, en perspective et en éclaté, un dispositif de commande de type bouton tournant muni du dispositif de fixation des figures 1 à 3,
- la figure 5 représente, en coupe longitudinale axiale, le dispositif de commande de la figure 4 assemblé sur une paroi,
- la figure 6 représente une variante de réalisation du dispositif de fixation de l'invention employée pour un montage affleurant du dispositif de commande,
- la figure 7 représente, en perspective et en éclaté, un dispositif de commande de type bouton tournant muni du dispositif de fixation de la figure 6,
- la figure 8 représente, vu de côté, un détail du dispositif de commande de la figure 7 assemblé sur une paroi par exemple en matériau plastique.

L'invention concerne un dispositif de commande ou de signalisation, par exemple de type bouton-poussoir, bouton tournant ou voyant lumineux susceptible de s'engager dans une ouverture 20 formée à travers une paroi 2 métallique, telle que par exemple la porte d'une armoire électrique ou un pupitre de commande. Pour un bouton-poussoir ou tournant, l'ouverture 20 est par exemple de diamètre normalisé égal à 22 mm ou 25,5mm.

Dans la suite de la description et sur les dessins, nous nous intéresserons plus particulièrement à un dispositif de commande de type bouton tournant. Cependant, il faut comprendre que l'invention décrite ci-dessous peut s'appliquer à tout type d'organe analogue doté d'une même architecture.

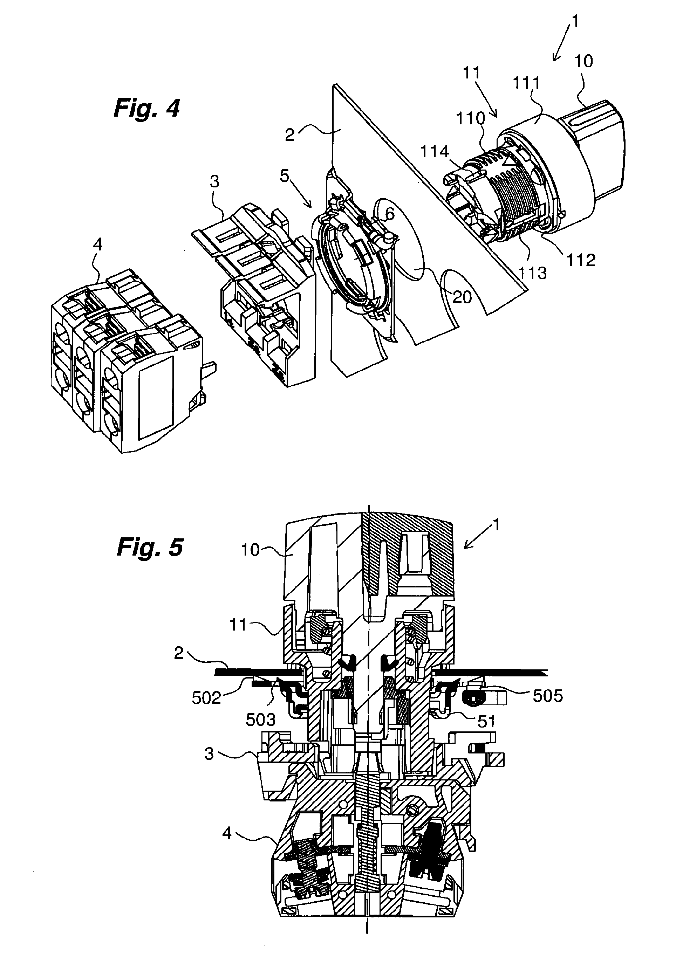

En référence aux figure 4 et 5, un dispositif de commande de type bouton tournant comporte un corps 1 tubulaire sur lequel est monté un organe de commande 10 rotatif et apte à venir s'engager dans l'ouverture 20 réalisée à travers la paroi 2. Le corps 1 tubulaire comporte une partie cylindrique 11 dotée d'une portion 110 filetée traversant l'ouverture et une collerette 111 formant un épaulement 112 avec la partie cylindrique 11, qui dans un montage dit classique, vient prendre appui sur une première face de la paroi 2 autour de l'ouverture 20. Le dispositif de commande comporte également une embase 3 de fixation par exemple de forme rectangulaire. Cette embase 3 comporte une ouverture centrale destinée à être traversée par la partie cylindrique 11 du corps 1 tubulaire et des moyens de fixation servant à porter de manière amovible des blocs électriques 4 amovibles tels que blocs de contact interrupteurs ou blocs auxiliaires.

Pour fixer le corps 1 tubulaire sur la paroi 2, le dispositif de commande comporte un dispositif de fixation 5 venant s'appliquer contre une deuxième face de la paroi 2, opposée à la première face, de manière à venir serrer le dispositif de commande sur la paroi 2. Ce dispositif de fixation 5 comporte une plaque de fixation 50 et un anneau de serrage 51 venant se visser sur la portion filetée 110 de la partie cylindrique 11 du corps 1.

II est connu que le corps 1 tubulaire du dispositif peut être en matériau métallique ou en matériau plastique. Dans la suite de la description, nous nous intéresserons à un dispositif de commande doté d'un corps 1 en matériau métallique.

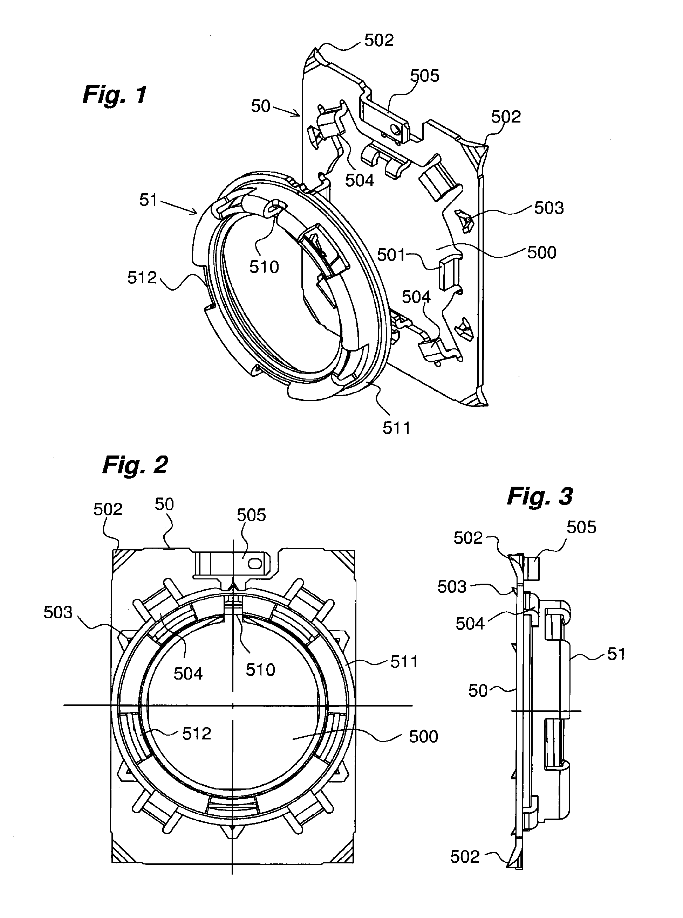

En référence aux figures 1 à 3, la plaque de fixation 50 est réalisée en matériau métallique et comporte une ouverture 500 destinée à être positionnée de manière coaxiale à l'ouverture 20 de la paroi 2 pour laisser passer la partie cylindrique 11 du corps 1 du dispositif de commande.

La plaque de fixation 50 comporte également sur le pourtour de son ouverture 500 des moyens de guidage permettant de guider le corps 1 dans l'ouverture 500 et de régler sa position par rapport à la plaque 50. Ces moyens de guidage comportent des ergots 501 destinés à coopérer avec une rainure 113 réalisée sur la partie cylindrique 11 du corps 1 tubulaire. Ces ergots 501 sont dimensionnés pour coopérer avec un corps 1 en matériau métallique et empêcher le montage d'un dispositif de fixation sur un corps 1 en matériau plastique, ceci pour éviter tout risque de détérioration du corps en matériau plastique.

La plaque de fixation 50 est par exemple de forme rectangulaire et comporte à chacun de ses coins une pointe saillante 502 destinée chacune à venir en contact avec la seconde face de la paroi 2. Ces pointes saillantes 502 permettent de pouvoir tourner la plaque, et donc le dispositif, pour régler sa position en rotation. Ces pointes saillantes permettent également, après serrage définitif, d'immobiliser le dispositif et d'empêcher sa rotation lorsqu'un utilisateur manipule l'organe de commande 10 en rotation.

Sur le pourtour de son ouverture 500, la plaque de fixation 50 comporte plusieurs autres pointes saillantes 503 destinées à venir en contact avec la paroi 2 pour réaliser la mise à la terre de la plaque de fixation 50. Leur forme saillante est étudiée pour pouvoir éventuellement perforer une couche de peinture réalisée sur la paroi 2. Les pointes saillantes 502 sont les premières à venir en contact avec le panneau et permettent de visualiser l'orientation de la plaque de fixation 50 avant le serrage complet. Comme le corps 1 est guidé dans la plaque de fixation 50 par les moyens de guidage formés par les ergots 501, l'orientation de la plaque de fixation 50 permet de visualiser l'orientation future de l'embase 3 de fixation et donc des blocs électriques 4 fixés sur l'embase 3. En positionnant la plaque de fixation 50 de manière verticale, il est certain que l'embase 3 de fixation sera positionnée de manière verticale. Les autres pointes saillantes 503 sont quant à elles destinées à la mise à la terre du dispositif lors du serrage.

La partie cylindrique 11 du corps 1 comporte sous la portion filetée 110 un ergot 114 destiné à coopérer avec une fente 510 (figure 2) correspondante réalisée sur l'intérieur de l'anneau de serrage 51. Cette fente 510 est présente sur un anneau de serrage réalisé en matériau métallique mais pas sur un anneau de serrage réalisé en matériau plastique. Ainsi, la présence de l'ergot 114 permet de n'autoriser que le montage d'un anneau de serrage métallique sur un corps en matériau métallique et permet de s'assurer de la mise à la terre du dispositif métallique par rapport à l'utilisateur. Cet ergot 114 est également agencé sur le corps 1 du dispositif pour stopper le mouvement de rotation de l'anneau de serrage 51 lors de son dévissage.

Selon l'invention, la plaque de fixation 50 comporte des moyens de maintien permettant de solidariser l'anneau de serrage à la plaque de fixation. Ces moyens de maintien sont constitués de plusieurs rabats, par exemple quatre rabats 504, réalisés sur le pourtour de l'ouverture 500 de la plaque de fixation 50 et s'appliquant sur une surface 511 circulaire extérieure de l'anneau de serrage 51. Ces moyens de maintien sont agencés pour bloquer l'anneau de serrage 51 en translation par rapport à la plaque 50 mais pour laisser l'anneau de serrage 51 libre en rotation autour de l'axe de l'ouverture.

La paroi 2 métallique étant reliée à la terre, la liaison mécanique entre la plaque de fixation 50 et l'anneau de serrage 51 permet de réaliser directement la mise à la terre du dispositif de commande en reliant le corps 1 tubulaire du dispositif à la paroi 2 métallique lors du serrage du dispositif sur la paroi métallique. En effet, le corps 1 tubulaire du dispositif étant métallique, il se trouve connecté à l'anneau de serrage 51 métallique lors du vissage, l'anneau de serrage 51 étant connecté à la plaque de fixation 50 par l'intermédiaire des rabats 504 et la plaque de fixation 50 connectée à la paroi métallique par l'intermédiaire des pointes saillantes 502.

Selon l'invention, l'anneau de serrage 51 peut comporter des crans de serrage 512 compatibles avec un outil de serrage permettant de visser ou dévisser l'anneau de serrage sur la portion filetée du corps du dispositif.

Selon l'invention, si la paroi 2 n'est pas métallique, le dispositif peut être mis à la terre en connectant une cosse 6 (figure 4) reliée à la terre sur une borne 505 réalisée sur la plaque de fixation 50.

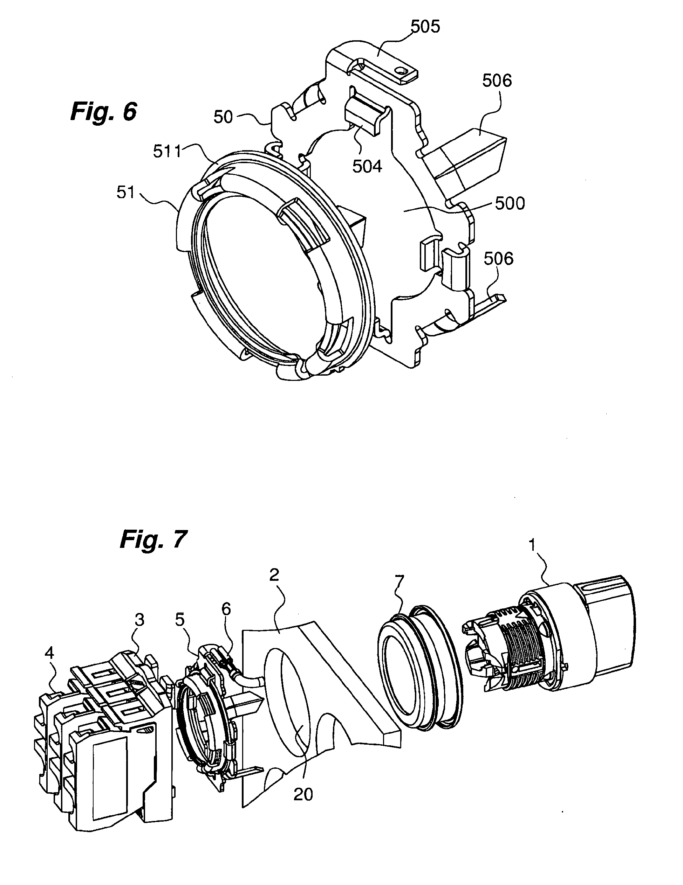

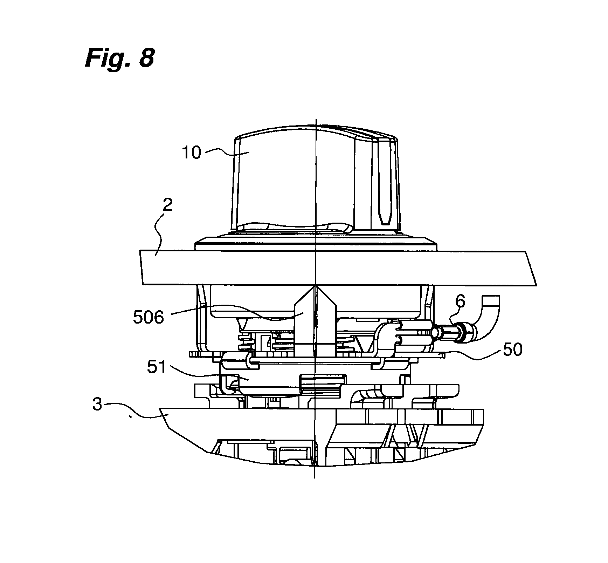

Selon une variante de réalisation représentée sur les figures 6 à 8, la plaque de fixation 50 peut être modifiée de manière à réaliser un montage affleurant du dispositif de commande (figure 8). Pour cela, les pointes saillantes 502, 503 sont remplacées par des dents saillantes 506 se dressant en direction de la paroi 2 et venant en contact avec la paroi lors du vissage de l'anneau de serrage 51 sur le corps du dispositif. Ces dents 506 s'étendent donc sur la distance présente entre la paroi et la portion filetée du corps 1. Si la paroi est métallique, ces dents 506 permettent d'assurer la liaison de terre entre la paroi 2 et le corps 1 métallique du dispositif. Comme décrit précédemment, si la paroi est en plastique, une borne 505 est également prévue sur la plaque de fixation 50 pour recevoir une cosse 6 reliée à la terre. Pour le montage affleurant du dispositif, un joint 7 (figure 7) enfoncé dans l'ouverture 20 réalisée à travers la paroi 2 peut être prévu pour former une barrière d'étanchéité entre l'organe de commande 10 et les blocs électriques 4. Par ailleurs, le dispositif de fixation et son principe restent identiques à ceux décrits ci-dessus dans le cas d'un montage classique.

Il est bien entendu que l'on peut, sans sortir du cadre de l'invention, imaginer d'autres variantes et perfectionnements de détail et de même envisager l'emploi de moyens équivalents.

## Revendications

1. Dispositif de commande ou de signalisation électrique destiné à être assemblé à travers une ouverture (20) réalisée dans une paroi (2) et comportant un corps (1) métallique tubulaire destiné à venir en appui contre une première face de la paroi (2), le corps (1) comportant une partie cylindrique (10) filetée destinée à être engagée dans l'ouverture (2) et un dispositif de fixation (5) comportant un anneau de serrage (51) métallique apte à se visser sur la partie cylindrique (10) filetée du corps pour fixer le dispositif de commande ou de signalisation à travers l'ouverture (2), **caractérisé en ce que** le dispositif de fixation (5) comporte également une plaque de fixation (50) métallique destinée à venir s'appliquer contre une deuxième face de la paroi (2), opposée à la première face, sous l'action de l'anneau de serrage (51), ladite plaque de fixation (50) comportant une ouverture (500) destinée à être traversée par le corps (10) du dispositif et des moyens de maintien de l'anneau de serrage (51) permettant de solidariser l'anneau de serrage (51) à la plaque de fixation (50), lesdits moyens de maintien étant agencés pour empêcher une translation de l'anneau de serrage (51) par rapport à la plaque de fixation (50) et pour laisser l'anneau de serrage (51) libre en rotation par rapport à la plaque de fixation (50).

2. Dispositif selon la revendication 1, **caractérisé en ce que** la plaque de fixation (50) comporte des pointes saillantes (502, 503) destinées à venir en contact avec la deuxième face de la paroi (2).

3. Dispositif selon la revendication 1, **caractérisé en ce que** la plaque de fixation comporte des dents saillantes (506) se dressant pour venir en contact avec la paroi et agencées pour assurer un montage affleurant du dispositif de commande ou de signalisation dans l'ouverture (20).

4. Dispositif selon l'une des revendications 1 à 3, **caractérisé en ce que** les moyens de maintien comportent plusieurs rabats (504) répartis sur le pourtour de l'ouverture (500) réalisée à travers la plaque de fixation (50).

5. Dispositif selon l'une des revendications 1 à 4, **caractérisé en ce que** la plaque de fixation (50) comporte des moyens de guidage du corps (1) du dispositif de commande ou de signalisation.

6. Dispositif selon l'une des revendications 1 à 5, **caractérisé en ce que** la partie cylindrique (10) du corps (1) comporte un ergot (114) destiné à coopérer avec une fente (510) correspondante de l'anneau de serrage (51).

7. Dispositif selon l'une des revendications 1 à 6, **caractérisé en ce que** la plaque de fixation (50) comporte une borne (505) de connexion apte à se raccorder à une cosse (6) connectée à un fil de terre.

## Patentansprüche

1. Elektrische Steuerungs- oder Signalgebungsvorrichtung, die dazu bestimmt ist, durch eine in einer Wand (2) ausgebildete Öffnung (20) zusammengefügt zu werden, und einen rohrförmigen Metallkörper (1) umfasst, der dazu bestimmt ist, sich an einer ersten Fläche der Wand (2) abzustützen, wobei der Körper (1) einen zylindrischen Gewindeabschnitt (10), der dazu bestimmt ist, in der Öffnung (2) in Eingriff zu gelangen, und eine Befestigungsvorrichtung (5), die einen metallischen Klemmring (51) aufweist, der auf den zylindrischen Gewindeabschnitt (10) des Körpers geschraubt werden kann, um die Steuerungs- und Signalgebungsvorrichtung durch die Öffnung (2) zu befestigen, umfasst, **dadurch gekennzeichnet, dass** die Befestigungsvorrichtung (5) außerdem eine metallische Befestigungsplatte (50) umfasst, die dazu bestimmt ist, unter der Wirkung des Klemmrings (51) gegen eine zweite Fläche der Wand (2) gegenüber der ersten Fläche gedrückt zu werden, wobei die Befestigungsplatte (50) eine Öffnung (500), die dazu bestimmt ist, von dem Körper (10) der Vorrichtung durchdrungen zu werden, und Mittel zum Halten des Klemmrings (51), die ermöglichen, den Klemmring (51) an der Befestigungsplatte (50) zu befestigen, umfasst, wobei die Haltemittel dafür ausgelegt sind, eine translatorische Bewegung des Klemmrings (51) in Bezug auf die Befestigungsplatte (50) zu verhindern und den Klemmring (51) in Bezug auf die Befestigungsplatte (50) frei drehbar zu lassen.

2. Vorrichtung nach Anspruch 1, **dadurch gekennzeichnet, dass** die Befestigungsplatte (50) vorstehende Spitzen (502, 503) aufweist, die dazu bestimmt sind, mit der zweiten Fläche der Wand (2) in Kontakt zu gelangen.

3. Vorrichtung nach Anspruch 1, **dadurch gekennzeichnet, dass** die Befestigungsplatte vorstehende Zähne (506) aufweist, die so vorragen, dass sie mit der Wand in Kontakt gelangen, und dafür ausgelegt sind, eine bündige Montage der Steuerungs- oder Signalgebungsvorrichtung in der Öffnung (20) sicherzustellen.

4. Vorrichtung nach einem der Ansprüche 1 bis 3, **dadurch gekennzeichnet, dass** die Haltemittel mehrere Laschen (504) aufweisen, die längs des Umfangs der Öffnung (500), die durch die Befestigungsplatte (50) verwirklicht ist, verteilt sind.

5. Vorrichtung nach einem der Ansprüche 1 bis 4, **dadurch gekennzeichnet, dass** die Befestigungsplatte (50) Mittel (1) zum Führen des Körpers der Steuerungs- oder Signalgebungsvorrichtung umfasst.

6. Vorrichtung nach einem der Ansprüche 1 bis 5, **dadurch gekennzeichnet, dass** der zylindrische Abschnitt (10) des Körpers (1) eine Nase (114) aufweist, die dazu bestimmt sind, mit einem entsprechenden Schlitz (510) des Klemmrings (51) zusammenzuwirken.

7. Vorrichtung nach einem der Ansprüche 1 bis 6, **dadurch gekennzeichnet, dass** die Befestigungsplatte (50) einen Verbindungsanschluss (505) aufweist, der mit einem mit einem Erddraht verbundenen Steckverbinder (6) verbunden werden kann.

## Claims

1. An electric control or signaling device intended to be assembled through an opening (20) formed in a wall (2) and including a tubular metal body (1) intended to come to bear against a first face of the wall (2), the body (1) including a threaded cylindrical part (10) intended to be engaged in the opening (2) and a fixing device (5) including a metal clamping ring (51) adapted to be screwed onto the threaded cylindrical part (10) of the body to fix the control or signal device through the opening (2), **characterized in that** the fixing device (5) also includes a metal fixing plate (50) intended to be applied against a second face of the wall (2), opposite the first face, by virtue of the action of the clamping ring (51), said fixing plate (50) including an opening (500) intended to have the body (10) of the device pass through it and means for retaining the clamping ring (51) enabling the clamping ring (51) to be fastened to the fixing plate (50), said retaining means being adapted to prevent movement in translation of the clamping ring (51) relative to the fixing plate (50) and to leave the clamping ring (51) free to rotate relative to the fixing plate (50).

2. The device as claimed in claim 1, **characterized in that** the fixing plate (50) includes projecting points (502, 503) intended to come into contact with the second face of the wall (2).

3. The device as claimed in claim 1, **characterized in that** the fixing plate includes projecting teeth (506) upstanding so as to come into contact with the wall and adapted to provide flush mounting of the control or signaling device in the opening (20).

4. The device as claimed in any one of claims 1 to 3, **characterized in that** the retaining means include a plurality of clips (504) distributed over the perimeter of the opening (500) formed through the fixing plate (50).

5. The device as claimed in any one of claims 1 to 4, **characterized in that** the fixing plate (50) includes means for guiding the body (1) of the control or signaling device.

6. The device as claimed in any one of claims 1 to 5, **characterized in that** the cylindrical part (10) of the body (1) includes a lug (114) intended to cooperate with a corresponding slot (510) of the clamping ring (51).

7. The device as claimed in any one of claims 1 to 6, **characterized in that** the fixing plate (50) includes a connecting terminal (505) adapted to be connected to a terminal (6) connected to a ground wire.
